# EUROPEAN PATENT SPECIFICATION

(11) **EP 2 707 912 B1**
(45) Date of publication and mention of the grant of the patent: **17.04.2019**
(21) Application number: 12722785.8
(22) Date of filing: 02.05.2012
(51) Int. Cl.: H01L 51/54

(54) **ORGANIC LIGHT EMISSIVE MATERIAL AND DEVICE**
ORGANISCHES LICHTEMITTIERENDES MATERIAL UND VORRICHTUNG
MATÉRIAU ET DISPOSITIF ÉLECTROLUMINESCENT ORGANIQUE

(30) Priority: 12.05.2011 GB 201107917
(43) Date of publication of application: 19.03.2014
(73) Proprietor: Cambridge Display Technology Limited, Cardinal Way Godmanchester Cambridgeshire PE29 2XG (GB); Sumitomo Chemical Company Limited, Tokyo 104-8260 (JP)
(72) Inventor: STEUDEL, Annette, Cambridgeshire CB23 6DW (GB)
(74) Representative: Gilani, Anwar
(86) International application number: PCT/GB2012/000401
(87) International publication number: WO 2012/153082

(56) References cited:
- EP-A1- 1 962 564
- EP-A1- 2 172 989
- WO-A1-2008/025997
- GB-A- 2 456 788
- JP-A- 2005 071 983
- US-A1- 2008 169 756
- US-A1- 2009 001 875
- X. GONG ET AL.: "Phosphorescence from iridium complexes doped into polymer blends", JOURNAL OF APPLIED PHYSICS, vol. 95, no. 3, 1 February 2004 (2004-02-01), pages 948-953, XP002679792,
- J. HWANG ET AL.: "Photoelectron spectroscopic study of the electronic band structure of polyfluorene and fluorene-arylamine copolymers at interfaces", JOURNAL OF PHYSICAL CHEMISTRY C, vol. 111, 16 December 2006 (2006-12-16), pages 1378-1384, XP002679793,
- JIA-LING LIAO ET AL: "Os(II) Phosphors with Near-Infrared Emission Induced by Ligand-to-Ligand Charge Transfer Transition", INORGANIC CHEMISTRY, vol. 53, no. 17, 2 September 2014 (2014-09-02), pages 9366-9374, XP55267887, EASTON, US ISSN: 0020-1669, DOI: 10.1021/ic501474r

## Description

### Summary of the Invention

The present invention relates to phosphorescent organic light-emitting materials, methods of making the same, and organic light-emitting devices containing the same.

### Background

Electronic devices containing active organic materials are attracting increasing attention for use in devices such as organic light emitting diodes (OLEDs), organic photoresponsive devices (in particular organic photovoltaic devices and organic photosensors), organic transistors and memory array devices. Devices containing active organic materials offer benefits such as low weight, low power consumption and flexibility. Moreover, use of soluble organic materials allows use of solution processing in device manufacture, for example inkjet printing or spin-coating.

An OLED may comprise a substrate carrying an anode, a cathode and one or more organic light-emitting layers between the anode and cathode.

Holes are injected into the device through the anode and electrons are injected through the cathode during operation of the device. Holes in the highest occupied molecular orbital (HOMO) and electrons in the lowest unoccupied molecular orbital (LUMO) of a light-emitting material combine to form an exciton that releases its energy as light.

Suitable light-emitting materials include small molecule, polymeric and dendrimeric materials. Suitable light-emitting polymers include poly(arylene vinylenes) such as poly(p-phenylene vinylenes) and polyarylenes such as polyfluorenes.

A light emitting layer may comprise a semiconducting host material and a light-emitting dopant wherein energy is transferred from the host material to the light-emitting dopant. For example, J. Appl. Phys. 65, 3610, 1989 discloses a host material doped with a fluorescent light-emitting dopant (that is, a light-emitting material in which light is emitted via decay of a singlet exciton).

Phosphorescent dopants are also known (that is, a light-emitting dopant in which light is emitted via decay of a triplet exciton).

Metal complexes having a bridge between two rings of a bidentate ligand are disclosed in US 2003/235712 and US 2008/161567.

Thin Solid Films, 516, 6186, 2008 discloses a phosphorescent light-emitting material having the following structures:

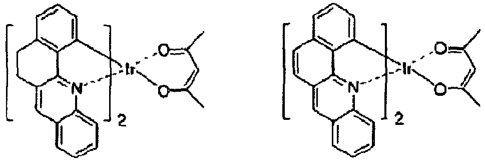

Emission from more than one layer of an OLED, in particular to achieve white light emission, is disclosed in, for example, WO 2008/131750, DE 102007020644 and EP1390962 and SPIE (2004), 5519, 42-47.

WO 2009/157424 discloses a phosphorescent material having the following structure:

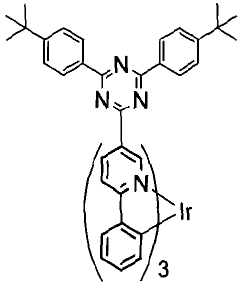

White light-emitting OLEDs comprising a single light-emitting layer are disclosed in, for example, WO2009/ 093033 and Advanced Material 2006, 18, 1769-1773 "High-Efficiency White Light Emitting Devices from a Single Polymer by Mixing Singlet and Triplet Emission".

EP 1962564 discloses a white organic electroluminescent device comprising a latimate of at least two light-emitting layers emitting light of different colours.

EP 2172989 discloses an organic light-emitting element having a light-emitting layer containing a polymer compound derived from an electron transport polymerizable compound and a phosphorescent polymerizable compound.

US 2009/001875 discloses an organic light-emitting device incorporating a multifunctional osmium complex.

### Summary of the Invention

In a first aspect the invention provides an organic light-emitting device according to the claims comprising a first electrode, a second electrode and at least one light-emitting layer between the first and second electrodes wherein the device comprises a plurality of light-emitters that together provide a source of white light; wherein a first light-emitting layer comprises a host material and a first light-emitter of the plurality of light-emitters that emits light having a peak photoluminescent wavelength in the range of 580-605 nm; and wherein a LUMO of the first light-emitter is the same or closer to vacuum than a LUMO level of the host material.

Optionally, the first light-emitting layer comprises each of the plurality of light-emitters that together provide a source of white light.

Optionally, the device comprises the first light-emitting layer and at least one further light-emitting layer, each of the at least one further light-emitting layers containing at least one of the light-emitters that together with the first light-emitter provide a source of white light.

Optionally, the first electrode is an anode; the second electrode is a cathode; and a hole transporting layer is disposed between the first electrode and the at least one light-emitting layer, wherein optionally the hole transporting layer is substantially non-emissive.

At least one of the plurality of light-emitters is phosphorescent. Optionally, the plurality of light-emitters are all phosphorescent.

Optionally, the host material is blended with the first light-emitter and any other of the plurality of light-emitters present in the first light-emitting layer.

Optionally, the host material is bound to at least one of the first light-emitter and any other of the plurality of light-emitters present in the first light-emitting layer. Optionally, the host material is a polymer and the at least one light-emitter bound to the host material is provided as a repeat unit in a main chain of the polymer or in a side chain or end group of the polymer.

The host material has formula (VII): 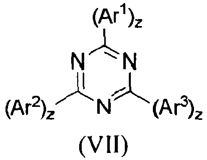 wherein Ar¹, Ar² and Ar³ are independently in each occurrence an optionally substituted aryl or heteroaryl group, and z independently in each occurrence is at least 1, optionally 1, 2 or 3.

The at least one phosphorescent emitter has formula (I):

ML¹_{q}L²ᵣL³ₛ (I)

wherein M is a metal; L¹, L² and L³ each independently represent a coordinating group; q is an integer; r and s are each independently 0 or an integer; and the sum of (a. q) + (b. r) + (c.s) is equal to the number of coordination sites available on M, wherein a is the number of coordination sites on L¹, b is the number of coordination sites on L²; and c is the number of coordination sites on L³.
L¹ is a coordinating group of formula (II): 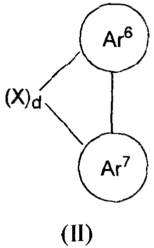
wherein Ar⁶ and Ar⁷ each independently represent an optionally substituted aromatic or heteroaromatic group comprising an atom capable of coordinating to M, d is at least 1 and X in each occurrence is selected from the group consisting of O, S, NR⁷ and -CR⁷₂-wherein R⁷ in each occurrence is H or a substituent, optionally H or C₁₋₂₀alkyl. Optionally, Ar⁶ comprises a N atom capable of coordinating to M and Ar⁷ comprises a C atom capable of coordinating to M.

Optionally, the plurality of light-emitter that together provide a white light source include a blue light-emitter.

Optionally, the blue light-emitter is a fluorescent light-emitter.

Optionally, the blue light-emitter is a polymer comprising a blue light-emitting repeat unit of formula (V): 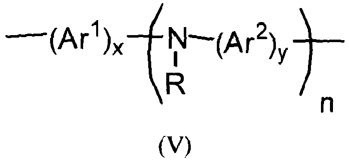 wherein Ar¹ and Ar² in each occurrence are independently selected from optionally substituted aryl or heteroaryl groups, n is greater than or equal to 1, preferably 1 or 2, R is H or a substituent, preferably a substituent, x and y are each independently 1, 2 or 3 and any of Ar¹, Ar² and R may be linked by a direct bond or a divalent linking group. Optionally, the blue light-emitter is the host.

Optionally, the blue light-emitter is a phosphorescent light-emitter.

Optionally, the plurality of light-emitters that together provide a white light source includes a green light-emitter.

Optionally, the green light-emitter is a phosphorescent light-emitter. The light-emitter having a peak wavelength in the range of 5 80-605 nm is a phosphorescent light-emitter.

Optionally, two or more of the plurality of light-emitter that together provide a source of white light are blended in the same light-emitting layer.

Optionally, two or more of the plurality of light-emitters that together provide a source of white light form part of the same molecule.

Optionally, the white light has a CIE x coordinate equivalent to that emitted by a black body at a temperature in the range of 2500-9000K, optionally in the range of 2700-4500K, and a CIE y coordinate within 0.05, optionally within 0.025, of the CIE y coordinate of said light emitted by a black body.

In a second aspect the invention provides a white light-emitting composition according to the claims comprising a plurality of light-emitters that together provide a source of white light, wherein one of the plurality of light-emitters emits light having a peak photo luminescent wavelength in the range of 580-610 nm.

Further the invention provides a plurality of light-emitters that together provide a source of white light comprises a phosphorescent metal complex of formula (I):

ML¹_{q}L²ᵣL³ₛ (I)

wherein M is a metal; L¹, L² and L³ each independently represent a coordinating group; q is an integer; r and s are each independently 0 or an integer; and the sum of (a. q) + (b. r) + (c.s) is equal to the number of coordination sites available on M, wherein a is the number of coordination sites on L¹, b is the number of coordination sites on L²; c is the number of coordination sites on L³; and L¹ is a coordinating group of formula (II): 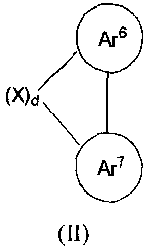 wherein Ar⁶ and Ar⁷ each independently represent an optionally substituted aromatic or heteroaromatic group comprising an atom capable of coordinating to M, d is at least 1 and X in each occurrence is selected from the group consisting of O, S, NR⁷ and -CR⁷₂-wherein R⁷ in each occurrence is H or a substituent, optionally H or C₁₋₂₀ alkyl.

### Brief Description of the Drawings

The invention will now be described in more detail with reference to the drawings, in which:
Figure 1 illustrates schematically an OLED according to a first embodiment of the invention;
Figure 2 illustrates schematically an OLED according to a second embodiment of the invention

### Detailed Description of the Invention

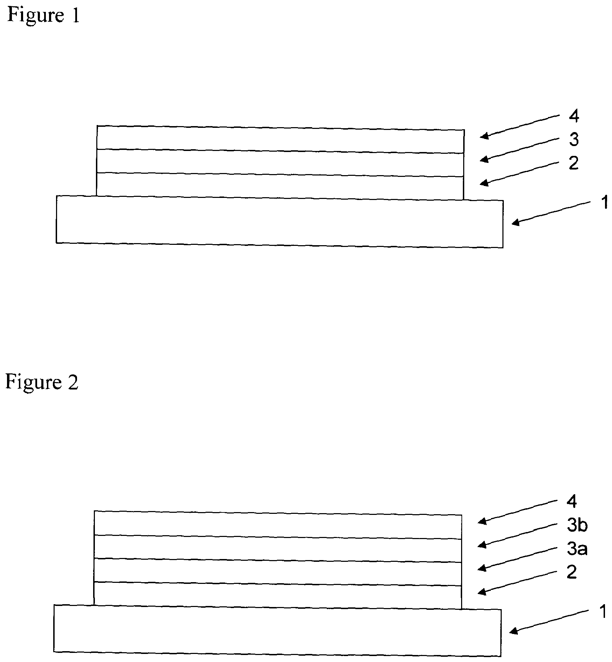

Figure 1, which is not drawn to any scale, illustrates schematically an OLED according to an embodiment of the invention. The OLED is carried on substrate 1 and comprises an anode 2, a cathode 4 and a light-emitting layer 3 between the anode and the cathode.

In operation, holes injected from the anode and electrons injected from the cathode combine in light-emitting layer 3 to form excitons.

The light-emitting layer 3 contains a plurality of light-emitters whose combined emissions provide white light. In this embodiment, substantially all light emitted by the device is emitted by light-emitting layer 3.

Figure 2, which is not drawn to any scale, illustrates schematically an OLED according to another embodiment of the invention. As with Figure 1, the OLED is carried on substrate 1 and comprises an anode 2 and a cathode 4. The OLED has two light-emitting layers 3a and 3b between the anode and the cathode. A plurality of light-emitters are provided in light-emitting layers 3a and 3b such that the combined emissions from these layers provide white light.

In yet further embodiments, three or more light-emitting layers may be provided.

Each of the aforementioned devices may have, in addition to the light-emitting layer or layers, one or more further layers between the anode and the cathode such as charge transporting and / or charge blocking layers.

In cases where the devices comprise more than one light-emitting layer, the colour of light emitted by the emitters of each layer may be substantially the same as or different to the light emitted by the other light-emitting layer or layers, with the proviso that the colour of light emitted by the device is white.

The wavelengths of light generated in the light-emitting layers may be emitted from the device substantially without alteration. Alternatively, an OLED may be provided with layers that alter the wavelengths of light emitted from the light-emitting layers. For example, a phosphor layer may be provided external to the electrodes to downconvert the colour of emission of one or more of the light-emitting materials in order to produce white light.

### Light-emitting layers

White light emission may be provided by numerous combinations of colours of light-emission, and the light-emitter may be selected accordingly.

For example, white light emission may be provided by a combination of orange, green and blue light generated by corresponding orange, green and blue light-emitter, each of which may be fluorescent or phosphorescent.

A blue light-emitter may have a photoluminescent spectrum with a peak at less than 480 nm, such as in the range of 400 nm up to less than 490 nm.

A green light-emitter may have a photoluminescent spectrum with a peak in the range of 490-560 nm.

An orange light-emitter may have a photoluminescent spectrum with a peak in the range of 580-610 nm.

Further light-emitter may be provided. For example, a red light-emitter having a photoluminescent spectrum with a peak in the range of above 610 nm up to about 630 nm and / or a yellow emitter having a photoluminescent spectrum with a peak in the range of greater than 560 up to less than 580 nm with may be provided.

The light-emitters that together provide white light may be provided in the same layer, for example in a device as illustrated in Figure 1. In the example of Figure 1, the relative molar quantities and / or energy levels of the light-emitting materials in light-emitting layer 3 may be selected so as to avoid significant quenching of one emitter by a lower energy emitter (for example, quenching of green emission by a lower energy orange emitter).

Alternatively, the light-emitters that together provide white light may be spread across multiple light-emitting layers, for example as illustrated in Figure 2.

Exemplary compositions include the following:
i) Orange, green and blue fluorescent light-emitters. The energy of blue singlet excitons may be absorbed by the green or orange fluorescent light emitters, and the energy of green singlet excitons may be absorbed and re-emitted by the orange fluorescent emitters. The relative concentrations of the emitters may be selected to take this into account, and in particular the concentration of the blue emitter may be greater than that of the green emitter which may in turn be present in higher concentration than the orange emitter.
ii) Blue fluorescent light-emitter with green and / or orange phosphorescent emitters. The triplet energy level of the blue fluorescent light-emitter may be higher than that of the phosphorescent emitters to avoid quenching of phosphorescence of either the green or orange phosphorescent emitters. In this case, the fluorescent emitter may function as a host material for the phosphorescent emitter.
iii) Orange, green and blue phosphorescent light-emitters with a host material having a triplet energy level higher than that of the blue phosphorescent light-emitter.
iv) Orange, red, green and blue phosphorescent light-emitters with a host material having a triplet energy level higher than that of the blue phosphorescent light-emitter.
v) Orange, yellow and blue phosphorescent light-emitters with a host material having a triplet energy level higher than that of the blue phosphorescent light-emitter.
vi) Orange, yellow, red and blue phosphorescent light-emitters with a host material having a triplet energy level higher than that of the blue phosphorescent light-emitter.

### Fluorescent light-emitters

Fluorescent emitters may be any form of material, including small molecule, polymeric and dendrimeric materials. Polymeric materials include materials that have a partially conjugated, fully conjugated or non-conjugated polymer backbone.

An exemplary emitter is at least partially conjugated polymeric emitter comprising optionally substituted (hetero)arylene repeat units, for example optionally substituted fluorene, phenylene and / or indenofluorene repeat units, and / or (hetero)arylamine repeat units.

An exemplary blue or green fluorescent polymer comprises at least 50 mol % of arylene repeat units, optionally more than 50 mol % of arylene repeat units, for example fluorene repeat units and / or phenylene repeat units, and up to 50 mol %, up to 30 mol % or up to 15 mol % of (hetero)arylamine repeat units.

Exemplary (hetero)arylamine repeat units include repeat units of formula (V): 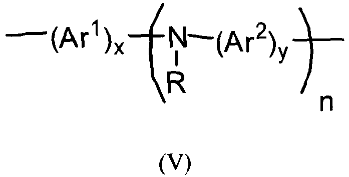
wherein Ar¹ and Ar² in each occurrence are independently selected from optionally substituted aryl or heteroaryl groups, n is greater than or equal to 1, preferably 1 or 2, R is H or a substituent, preferably a substituent, and x and y are each independently 1, 2 or 3.
R is preferably alkyl, for example C₁₋₂₀ alkyl, Ar³, or a branched or linear chain of Ar³ groups, for example -(Ar³)ᵣ, wherein Ar³ in each occurrence is independently selected from aryl or heteroaryl and r is at least 1, optionally 1, 2 or 3.

Any of Ar¹, Ar² and Ar³ may independently be substituted with one or more substituents. Preferred substituents are selected from the group R³ consisting of:
alkyl, for example C₁₋₂₀ alkyl, wherein one or more non-adjacent C atoms may be replaced with O, S, substituted N, C=O and -COO- and one or more H atoms of the alkyl group may be replaced with F or aryl or heteroaryl optionally substituted with one or more groups R⁴,
aryl or heteroaryl optionally substituted with one or more groups R⁴,
NR⁵₂, OR⁵, SR⁵,
fluorine, nitro and cyano, and
crosslinkable groups;
wherein each R⁴ is independently alkyl, for example C₁₋₂₀ alkyl, in which one or more non-adjacent C atoms may be replaced with O, S, substituted N, C=O and -COO- and one or more H atoms of the alkyl group may be replaced with F, and each R⁵ is independently selected from the group consisting of alkyl and aryl or heteroaryl optionally substituted with one or more alkyl groups.

R may comprise a crosslinkable-group, for example a group comprising a polymerisable double bond such and a vinyl or acrylate group, or a benzocyclobutane group.

Any of the aryl or heteroaryl groups in the repeat unit of Formula (V) may be linked by a direct bond or a divalent linking atom or group. Preferred divalent linking atoms and groups include O, S; substituted N; and substituted C.

Where present, substituted N or substituted C of R³, R⁴ or of the divalent linking group may independently in each occurrence be NR⁶ or CR⁶₂ respectively wherein R⁶ is alkyl or optionally substituted aryl or heteroaryl. Optional substituents for aryl or heteroaryl groups R⁶ may be selected from R⁴ or R⁵.

In one preferred arrangement, R is Ar³ and each of Ar¹, Ar² and Ar³ are independently and optionally substituted with one or more C₁₋₂₀ alkyl groups.

Particularly preferred units satisfying Formula 1 include units of Formulae 1-3: 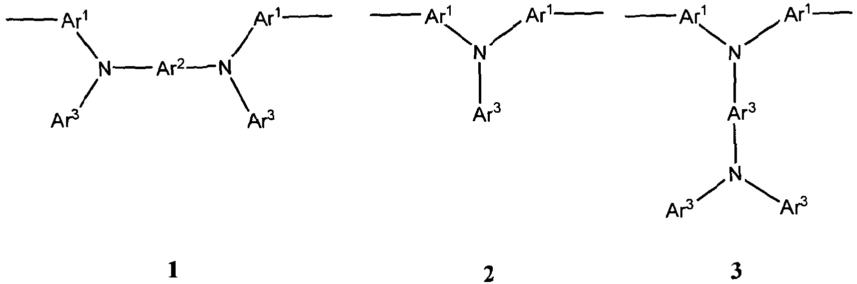
wherein Ar¹ and Ar² are as defined above; and Ar³ is optionally substituted aryl or heteroaryl. Where present, preferred substituents for Ar³ include substituents as described for Ar¹ and Ar², in particular alkyl and alkoxy groups.
Ar¹, Ar² and Ar³ are preferably phenyl, each of which may independently be substituted with one or more substituents as described above.

In another preferred arrangement, aryl or heteroaryl groups of formula (V) are phenyl, each phenyl group being optionally substituted with one or more alkyl groups.

In another preferred arrangement, Ar¹, Ar² and Ar³ are phenyl, each of which may be substituted with one or more C₁₋₂₀ alkyl groups, and r = 1.

In another preferred arrangement, Ar¹ and Ar² are phenyl, each of which may be substituted with one or more C₁₋₂₀ alkyl groups, and R is 3,5-diphenylbenzene wherein each phenyl may be substituted with one or more alkyl groups.

Exemplary fluorene repeat units include repeat units of formula IV: 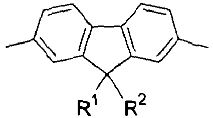 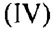
wherein R¹ and R² are independently H or a substituent and wherein R¹ and R² may be linked to form a ring.
R¹ and R² are optionally selected from the group consisting of hydrogen; optionally substituted Ar³ or a linear or branched chain of Ar³ groups, wherein Ar³ is as described above; and optionally substituted alkyl, for example C₁₋₂₀ alkyl, wherein one or more non-adjacent C atoms of the alkyl group may be replaced with O, S, substituted N, C=O and - COO-.

In the case where R¹ or R² comprises alkyl, optional substituents of the alkyl group include F, CN, nitro, and aryl or heteroaryl optionally substituted with one or more groups R⁴ wherein R⁴ is as described above.

In the case where R¹ or R² comprises aryl or heteroaryl, each aryl or heteroaryl group may independently be substituted. Preferred optional substituents for the aryl or heteroaryl groups include one or more substituents R³.

Optional substituents for the fluorene unit, other than substituents R¹ and R², are preferably selected from the group consisting of alkyl wherein one or more non-adjacent C atoms may be replaced with O, S, substituted N, C=O and -COO-, optionally substituted aryl, optionally substituted heteroaryl, fluorine, cyano and nitro.

Where present, substituted N in repeat units of formula (IV) may independently in each occurrence be NR⁵ or NR⁶.

In one preferred arrangement, at least one of R¹ and R² comprises an optionally substituted C₁-C₂₀ alkyl or an optionally substituted aryl group, in particular phenyl substituted with one or more C₁₋₂₀ alkyl groups.

R¹ and / or R² may be crosslinkable. For example, R¹ and / or R² may comprise a polymerisable double bond such and a vinyl or acrylate group, or a benzocyclobutane group.

Exemplary phenylene repeat units include repeat units of formula (VIII): 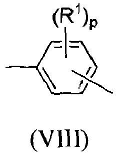 wherein R¹ is as described above with reference to formula (IV) and p is 1, 2, 3 or 4, optionally 1 or 2. In one arrangement, the repeat unit is a 1,4-phenylene repeat unit.

The repeat unit of formula (VIII) may have formula (VIIIa):

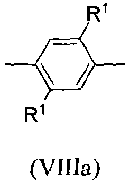

### Phosphorescent light-emitters

Phosphorescent light-emitters include metal complexes comprising optionally substituted complexes of formula (II):

ML¹_{q}L²ᵣL³ₛ (I)

wherein M is a metal; each of L¹, L² and L³ is a coordinating group; q is an integer; r and s are each independently 0 or an integer; and the sum of (a. q) + (b. r) + (c.s) is equal to the number of coordination sites available on M, wherein a is the number of coordination sites on L¹, b is the number of coordination sites on L² and c is the number of coordination sites on L³.

Heavy elements M induce strong spin-orbit coupling to allow rapid intersystem crossing and emission from triplet or higher states (phosphorescence). Suitable heavy metals M include d-block metals, in particular those in rows 2 and 3 i.e. elements 39 to 48 and 72 to 80, in particular ruthenium, rhodium, palladium, rhenium, osmium, iridium, platinum and gold. Iridium is particularly preferred.

Suitable coordinating groups for the f-block metals include oxygen or nitrogen donor systems such as carboxylic acids, 1,3-diketonates, hydroxy carboxylic acids, Schiff bases including acyl phenols and iminoacyl groups. As is known, luminescent lanthanide metal complexes require sensitizing group(s) which have the triplet excited energy level higher than the first excited state of the metal ion. Emission is from an f-f transition of the metal and so the emission colour is determined by the choice of the metal. The sharp emission is generally narrow, resulting in a pure colour emission useful for display applications.

Phosphorescent materials may be provided in an amount of 0.1-20 mol%, optionally 0.1-10 mol% in a light-emitting layer.

The d-block metals are particularly suitable for emission from triplet excited states. These metals form organometallic complexes with carbon or nitrogen donors such as porphyrin or bidentate ligands of formula (III): 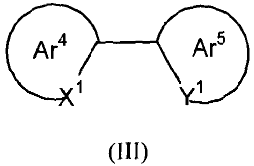 wherein Ar⁴ and Ar⁵ may be the same or different and are independently selected from optionally substituted aryl or heteroaryl; X¹ and Y¹ may be the same or different and are independently selected from carbon or nitrogen; and Ar⁴ and Ar⁵ may be linked by a linking group or fused together. Ligands wherein X¹ is carbon and Y¹ is nitrogen are particularly preferred.

Examples of bidentate ligands are illustrated below: 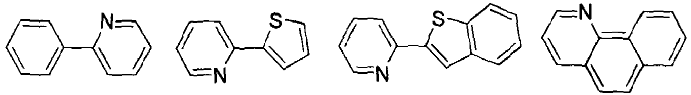 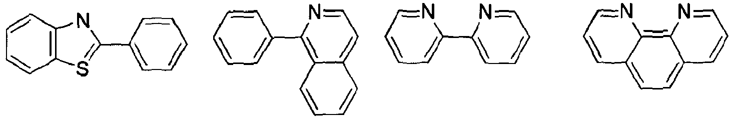 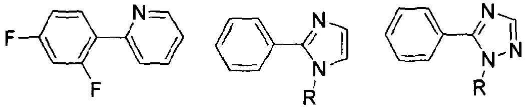 Each of Ar⁴ and Ar⁵ may carry one or more substituents. Two or more of these substituents may be linked to form a ring, for example an aromatic ring. Particularly preferred substituents include fluorine or trifluoromethyl which may be used to blue-shift the emission of the complex as disclosed in WO 02/45466, WO 02144189, US 2002-117662 and US 2002-182441; alkyl or alkoxy groups as disclosed in JP 2002-324679; carbazole which may be used to assist hole transport to the complex when used as an emissive material as disclosed in WO 02/81448; bromine, chlorine or iodine which can serve to functionalise the ligand for attachment of further groups as disclosed in WO 02/68435 and EP 1245659; and dendrons which may be used to obtain or enhance solution processability of the metal complex as disclosed in WO 02/6655.

Other ligands suitable for use with d-block elements include diketonates, in particular acetylacetonate (acac); triarylphosphines and pyridine, each of which may be substituted.

A light-emitting dendrimer typically comprises a light-emitting core bound to one or more dendrons, wherein each dendron comprises a branching point and two or more dendritic branches. Preferably, the dendron is at least partially conjugated, and at least one of the branching points and dendritic branches comprises an aryl or heteroaryl group, for example a phenyl group. In one arrangement, the branching point group and the branching groups are all phenyl, and each phenyl may independently be substituted with one or more substituents, for example alkyl or alkoxy.

A dendron may have optionally substituted formula (VI) 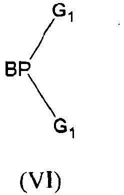 wherein BP represents a branching point for attachment to a core and G₁ represents first generation branching groups.

The dendron may be a first, second, third or higher generation dendron. G₁ may be substituted with two or more second generation branching groups G₂, and so on, as in optionally substituted formula (VIa): 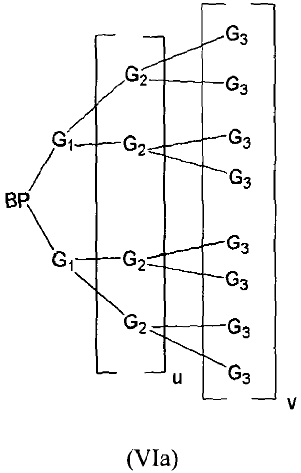
wherein u is 0 or 1; v is 0 if u is 0 or may be 0 or 1 if u is 1; BP represents a branching point for attachment to a core and G₁, G₂ and G₃ represent first, second and third generation dendron branching groups.
BP and / or any group G may be substituted with one or more substituents, for example one or more C₁₋₂₀ alkyl or alkoxy groups.

An exemplary phosphorescent green emitter of formula (I) is tris-phenylpyridine iridium (III), which may be substituted with one or more substituents, for example one or more substituents selected from substituents of Ar⁴ and Ar⁵ described above.

Exemplary phosphorescent blue emitters are compounds of formula (I) wherein M is Ir and one or more of the ligands is optionally substituted phenyltriazole (e.g. phenyltriazole substituted with one or more C₁₋₂₀ alkyl groups), as described in WO 20054/101707.

Exemplary orange emitters of formula (I) include the following compounds, each of which may optionally be substituted, for example with one or more substituents selected from substituents of Ar⁴ and Ar⁵ described above: 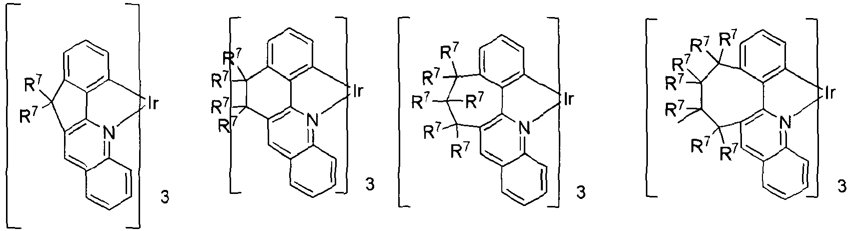 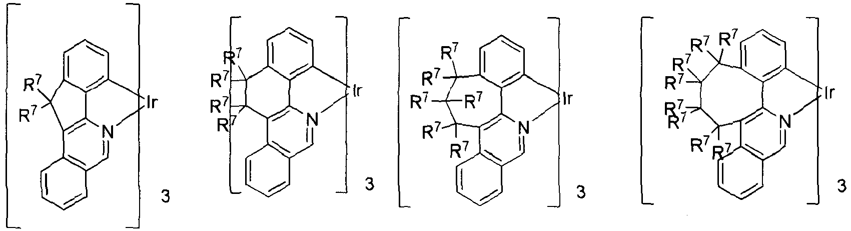 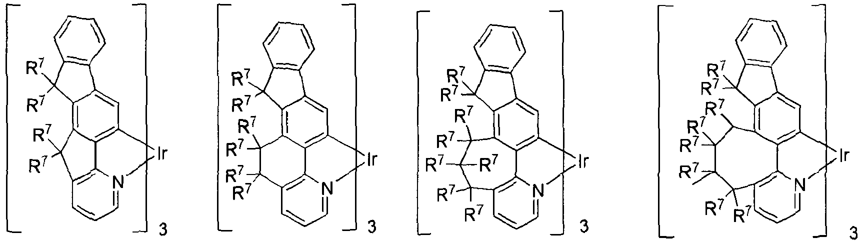 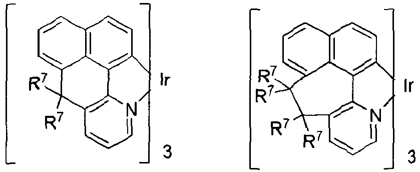 wherein R⁷ is as described above.

The orange emitters illustrated contain C-N cyclometalating bidentate ligands having a bridge that is one to four atoms in length between two coordinating rings of the ligand. If the bridge is one or two atoms in length, the material may have a peak emission wavelength that is shorter than that of a corresponding material in which the bridge is absent. The bridge may cause a twist in the dihedral angle θ between C1, C2, C3 and N of the ligand as illustrated in formula (IIa) and, without wishing to be bound by any theory, this twist may reduce conjugation within the ligand resulting in a shift to a shorter peak wavelength. 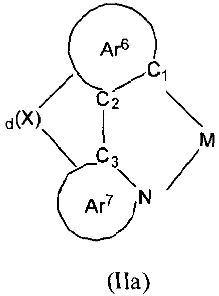 wherein X, d, M, Ar⁶ and Ar⁷ are as described with reference to formula (IIa), and θ is greater than the corresponding angle where -(X)_{d}- is not present. An exemplary range of angles θ is > 8°, more preferred > 10°. The dihedral angle can be calculated using the Gaussian 09 modelling package (Gaussian 09, Revision A.02, M. J. Frisch, G. W. Trucks, H. B. Schlegel, G. E. Scuseria, M. A. Robb, J. R. Cheeseman, G. Scalmani, V. Barone, B. Mennucci, G. A. Petersson, H. Nakatsuji, M. Caricato, X. Li, H. P. Hratchian, A. F. Izmaylov, J. Bloino, G. Zheng, J. L. Sonnenberg, M. Hada, M. Ehara, K. Toyota, R. Fukuda, J. Hasegawa, M. Ishida, T. Nakajima, Y. Honda, O. Kitao, H. Nakai, T. Vreven, J. A. Montgomery, Jr., J. E. Peralta, F. Ogliaro, M. Bearpark, J. J. Heyd, E. Brothers, K. N. Kudin, V. N. Staroverov, R. Kobayashi, J. Normand, K. Raghavachari, A. Rendell, J. C. Burant, S. S. Iyengar, J. Tomasi, M. Cossi, N. Rega, J. M. Millam, M. Klene, J. E. Knox, J. B. Cross, V. Bakken, C. Adamo, J. Jaramillo, R. Gomperts, R. E. Stratmann, O. Yazyev, A. J. Austin, R. Cammi, C. Pomelli, J. W. Ochterski, R. L. Martin, K. Morokuma, V. G. Zakrzewski, G. A. Voth, P. Salvador, J. J. Dannenberg, S. Dapprich, A. D. Daniels, Ö. Farkas, J. B. Foresman, J. V. Ortiz, J. Cioslowski, and D. J. Fox, Gaussian, Inc., Wallingford CT, 2009). Geometry optimisation was performed and orbital energies calculated with density functional theory (DFT) using the B3LYP functional and 6-31g(d) basis set on H, C and N atoms and LanL2DZ basis set on Ir atoms. Optical transition energies were calculated using time dependent DFT using the same functional and basis set as for the geometry optimization.

Accordingly, a suitable orange-emitting material may be a bridged analogue of a red-emitting material.

An orange-emitting metal complex of formula (I) may contain one or more ligands of formula (IIa) and may be a homoleptic or heteroleptic metal complex. An orange-emitting heteroleptic metal complex of formula (I) may comprise ligand L¹ of formula (II) and one or more further ligands L² and / or L³ selected from ligands of formula (III).

The orange-emitter may be a material that does not trap electrons. A material of a light-emitting composition that does not trap electrons may have a LUMO level that is less than 200 meV further from vacuum level than the LUMO level of any other component of the composition, and may have a LUMO level that is closer to vacuum level than any other component of the composition, or that is the same as one or more of the other components of the composition.

The HOMO and LUMO energy levels of a material may be measured by cyclic voltammetry (CV) wherein the working electrode potential is ramped linearly versus time. When cyclic voltammetry reaches a set potential the working electrode's potential ramp is inverted. This inversion can happen multiple times during a single experiment. The current at the working electrode is plotted versus the applied voltage to give the cyclic voltammogram trace.

Apparatus to measure HOMO or LUMO energy levels by CV may comprise a cell containing a tert-butyl ammonium perchlorate/ or tertbutyl ammonium hexafluorophosphate solution in acetonitrile, a glassy carbon working electrode where the sample is coated as a film, a platinium counter electrode (donor or acceptor of electrons) and a reference glass electrode no leak Ag/AgCl. Ferrocene is added in the cell at the end of the experiment for calculation purposes. (Measurement of the difference of potential between Ag/AgCl/ferrocene and sample/ferrocene).

### Method and settings:

3mm diameter glassy carbon working electrode
Ag/AgCl/no leak reference electrode
Pt wire auxiliary electrode
0.1 M tetrabutylammonium hexafluorophosphate in acetonitrile
LUMO = 4.8 - ferrocene (peak to peak maximum average) + onset
Sample: 1 drop of 5mg/mL in toluene spun @3000rpm LUMO (reduction) measurement: A good reversible reduction event is typically observed for thick films measured at 200 mV/s and a switching potential of -2.5V. The reduction events should be measured and compared over 10 cycles, usually measurements are taken on the 3^{rd} cycle. The onset is taken at the intersection of lines of best fit at the steepest part of the reduction event and the baseline.

Comparison of the LUMO levels of an electron transporting material and an electroluminescent material will reveal if the electron transporting material will function as an electron trap.

Alternatively, the electron trapping characteristics of an electroluminescent material (or absence thereof) may be established by measuring the electron current at fixed voltage for an electron-only device with and without a small percentage of said electroluminescent material. An electron-only device may comprise the following structure:
Al (15nm)/Electroluminescent material (60nm)/NaF (2nm)/Al (200nm)/Ag(100nm) Phosphorescent light-emitters may be used in combination with a host in a host-dopant arrangement. The host may be any material having an excited state (T₁) energy level that is higher than that of the dopant it is used with. Preferably, the gap between the host and dopant excited state energy levels is at least kT in order to avoid back transfer of excitons from the dopant to the host material. The host material is optionally solution processable. Suitable hosts for phosphorescent dopants, for example green or longer wavelength phosphorescent dopants, include optionally substituted diaryltriazines or triaryltriazines. Triazine-containing host materials are described in more detail in WO 2008/025997 and include, for example, a small molecule or polymer containing triazine. Exemplary triazine-containing polymers include polymers having optionally substituted di-or tri-(hetero)aryltriazine attached as a side group through one of the (hetero)aryl groups, or a repeat unit attached in the polymer main chain through two of the (hetero)aryl groups.

Triazine-containing host materials have formula (VII): 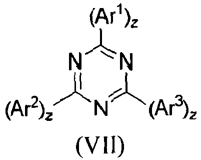 wherein Ar¹, Ar² and Ar³ are as described with reference to repeat units of formula (V) and z independently in each occurrence is at least 1, optionally 1, 2 or 3. Each of Ar¹, Ar² and Ar³ may independently be substituted with one or more substituents. In one arrangement, Ar¹, Ar² and Ar³ are phenyl in each occurrence. Exemplary substituents include R³ as described above with reference to repeat units of formula (V), for example C₁₋₂₀ alkyl or alkoxy.

Exemplary triazine repeat units of a polymeric host material have formula (VIIa): 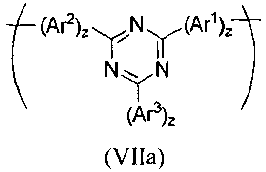 wherein Ar¹, Ar² and Ar³ and z are as described above.

Exemplary repeat units of a host polymer may include one or more of:
(i) (hetero)arylene co-repeat units, such as phenyl, fluorene or indenofluorene repeat units as described above, each of which may optionally be substituted, in particular fluorene repeat units of formula (IV) and / or phenylene repeat units of formula (VIII);
(ii) optionally substituted arylamine repeat units, in particular repeat units of formula (V) as described above; and / or
(iii) optionally substituted triazine repeat units, in particular repeat units of formula (VIIa)

A host polymer comprising aromatic repeat units may form conjugated chains of aromatic units. This conjugation may be interrupted or reduced by inclusion of suitable repeat units in the polymer backbone, such as repeat units that form a twist in the polymer backbone and repeat units that break conjugation.

An example of a repeat unit that may cause a twist in the polymer backbone (for example by steric hindrance) is 1,4-phenylene substituted with one or more groups such as one or more alkyl or alkoxy groups, e.g. C₁₋₂₀ alkyl or alkoxy groups, in particular 2,5-disubstituted-1,4-phenylene repeat units.

A class of repeat units that may break conjugation include arylene or heteroarylene repeat units that are linked to adjacent repeat units through non-conjugating positions. Exemplary units of this kind include 1,2-phenylene repeat units and 1,3-phenylene repeat units, each of which may optionally be substituted with one or more substituents such as one or more substituents R¹ as described above, in particular or more alkyl or alkoxy groups, e.g. C₁₋₂₀ alkyl or alkoxy groups, and fluorene repeat units linked through 2- and / or 6-positions which again may optionally be substituted with one or more substituents such as one or more substituents R¹ as described above.

The host and the light-emitting dopant or dopants may be physically mixed. Alternatively, the light-emitting dopant or dopants may be chemically bound to the host. In the case of a polymer host, the light-emitting dopant or dopants may be chemically bound as a substituent attached to the polymer backbone, incorporated as a repeat unit in the polymer backbone or provided as an end-group of the polymer as disclosed in, for example, EP 1245659, WO 02/31896, WO 03/18653, GB2435194 and WO 03/22908. If more than one light-emitting dopant is present then the host may be bound to one or more of the dopants, and blended with any remaining dopants.

This binding may result in more efficient transfer of excitons from the host polymer to the light emitting dopant because it may provide intramolecular exciton transfer pathways unavailable to a corresponding mixed system.

Moreover, binding may be beneficial for processing reasons. For example, if a light emitting dopant has low solubility then binding it to a soluble host material, such as a host polymer, allows the light emitting dopant to be carried in solution by the charge transporting material, enabling device fabrication using solution processing techniques. Furthermore, binding a light emitting dopant to a host may prevent phase separation effects in solution-processed devices that may be detrimental to device performance.

Examples of emitter attached as endgroup are illustrated below:

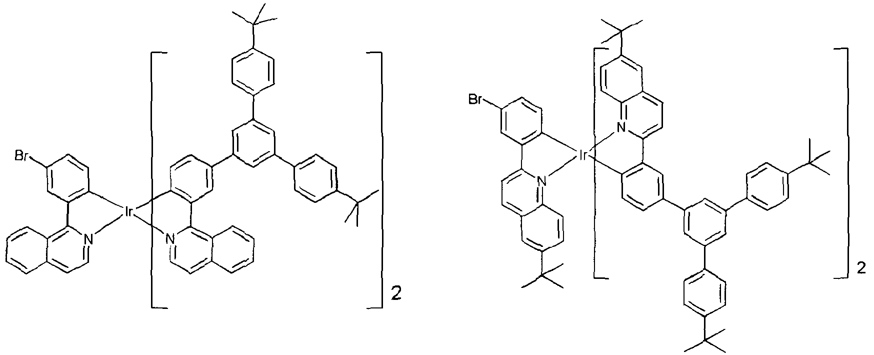

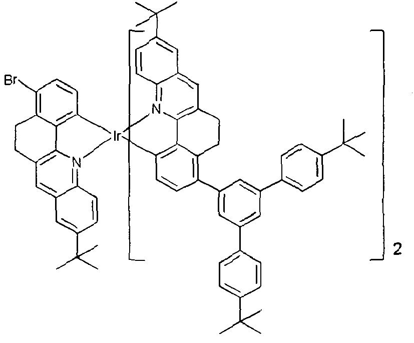

Examples of monomers that can be used to form repeat units of a polymer include the following:

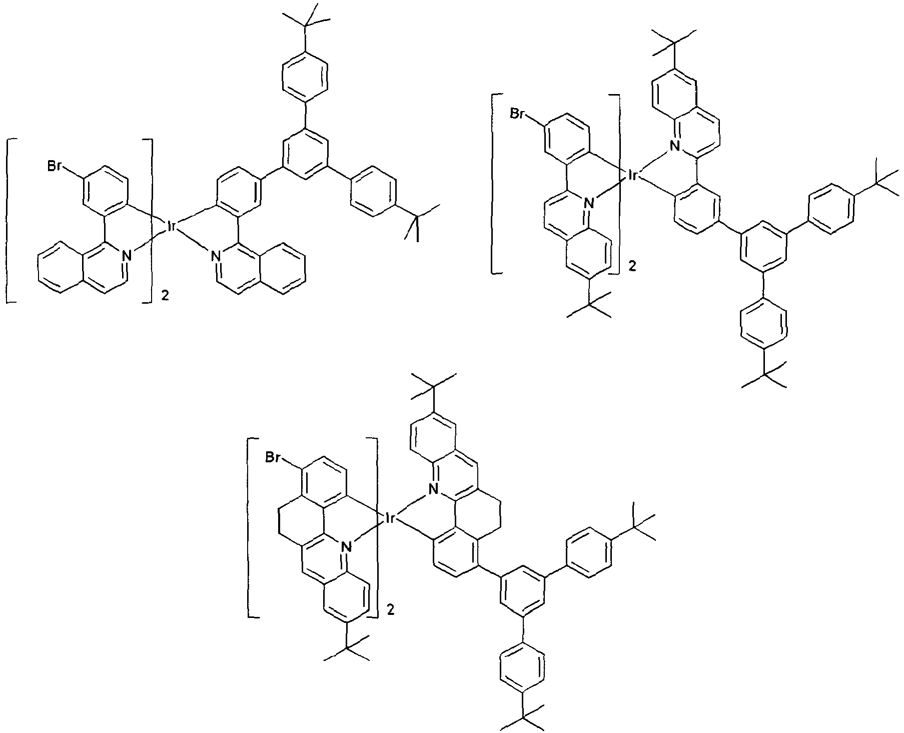

Emitters that can be provided as pendant from a polymer main chain include the following:

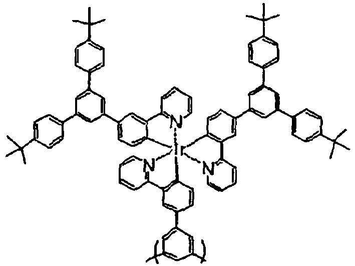

The emitters illustrated above as main chain, side chain or endgroup emitters of a polymer are phosphorescent orange or red emitters, however it will be appreciated that these emitters may have any colour, including green or blue.

### Polymer synthesis

Preferred methods for preparation of conjugated polymers, such as polymers comprising repeat units of formula (IV) and / or (V) as described above, comprise a "metal insertion" wherein the metal atom of a metal complex catalyst is inserted between an aryl or heteroaryl group and a leaving group of a monomer. Exemplary metal insertion methods are Suzuki polymerisation as described in, for example, WO 00/53656 and Yamamoto polymerisation as described in, for example, T. Yamamoto, "Electrically Conducting And Thermally Stable π - Conjugated Poly(arylene)s Prepared by Organometallic Processes", Progress in Polymer Science 1993, 17, 1153-1205. In the case of Yamamoto polymerisation, a nickel complex catalyst is used; in the case of Suzuki polymerisation, a palladium complex catalyst is used.

For example, in the synthesis of a linear polymer by Yamamoto polymerisation, a monomer having two reactive halogen groups is used. Similarly, according to the method of Suzuki polymerisation, at least one reactive group is a boron derivative group such as a boronic acid or boronic ester and the other reactive group is a halogen. Preferred halogens are chlorine, bromine and iodine, most preferably bromine.

It will therefore be appreciated that repeat units illustrated throughout this application may be derived from a monomer carrying suitable leaving groups. Likewise, an end group or side group may be bound to the polymer by reaction of a suitable leaving group.

Suzuki polymerisation may be used to prepare regioregular, block and random copolymers. In particular, homopolymers or random copolymers may be prepared when one reactive group is a halogen and the other reactive group is a boron derivative group. Alternatively, block or regioregular copolymers may be prepared when both reactive groups of a first monomer are boron and both reactive groups of a second monomer are halogen.

As alternatives to halides, other leaving groups capable of participating in metal insertion include sulfonic acids and sulfonic acid esters such as tosylate, mesylate and triflate.

### Charge transporting layers

A hole transporting layer may be provided between the anode and the light-emitting layer or layers. Likewise, an electron transporting layer may be provided between the cathode and the light-emitting layer or layers.

Similarly, an electron blocking layer may be provided between the anode and the light-emitting layer(s) and a hole blocking layer may be provided between the cathode and the light-emitting layer(s). Transporting and blocking layers may be used in combination. Depending on its HOMO and LUMO levels, a single layer may both transport one of holes and electrons and block the other of holes and electrons.

If present, a hole transporting layer located between the anode and the light-emitting layers preferably has a HOMO level of less than or equal to 5.5 eV, more preferably around 4.8-5.5 eV. The HOMO level of the hole transport layer may be selected so as to be within 0.2 eV, optionally within 0.1 eV, of an adjacent layer (such as a light-emitting layer) in order to provide a small barrier to hole transport between these layers.

If present, an electron transporting layer located between the light-emitting layers and cathode preferably has a LUMO level of around 3-3.5 eV. For example, a layer of a silicon monoxide or silicon dioxide or other thin dielectric layer having thickness in the range of 0.2-2nm may be provided between the light-emitting layer nearest the cathode and the cathode.

A hole transporting layer may contain a hole-transporting (hetero)arylamine, such as a homopolymer or copolymer comprising hole transporting repeat units of formula (V). Exemplary copolymers comprise repeat units of formula (V) and optionally substituted (hetero)arylene co-repeat units, such as phenyl, fluorene or indenofluorene repeat units as described above, wherein each of said (hetero)arylene repeat units may optionally be substituted with one or more substituents such as alkyl or alkoxy groups. Specific co-repeat units include fluorene repeat units of formula (IV) and optionally substituted phenylene repeat units of formula (VIII).

The hole-transporting layer may be crosslinkable, in particular if it is formed by depositing a hole transporting material from a solution in a solvent. For example a polymer comprising a repeat unit of formula (V), optionally with one or more arylene co-repeat units, may be provided with crosslinkable substituents on one or more of the arylene repeat units and repeat units of formula (V).

Likewise, an electron transporting layer may contain a polymer comprising a chain of optionally substituted arylene repeat units, such as a chain of fluorene repeat units.

In one exemplary arrangement, a charge transporting layer may emit light in addition to the one or more light-emitting layers described above. In another exemplary arrangement, a charge transporting layer may emit substantially no light.

### Hole injection layers

A conductive hole injection layer, which may be formed from a conductive organic or inorganic material, may be provided between the anode and the light-emitting layer(s) to assist hole injection from the anode into the hole transporting layer(s), if present, and the light-emitting layer(s). A hole transporting layer may be used in combination with a hole injection layer.

Examples of doped organic hole injection materials include optionally substituted, doped poly(ethylene dioxythiophene) (PEDT), in particular PEDT doped with a charge-balancing polyacid such as polystyrene sulfonate (PSS) as disclosed in EP 0901176 and EP 0947123, polyacrylic acid or a fluorinated sulfonic acid, for example Nafion ®; polyaniline as disclosed in US 5723873 and US 5798170; and optionally substituted polythiophene orpoly(thienothiophene). Examples of conductive inorganic materials include transition metal oxides such as VOx MoOx and RuOx as disclosed in Journal of Physics D: Applied Physics (1996), 29(11), 2750-2753.

### Cathode

The cathode is selected from materials that have a workfunction allowing injection of electrons into the light-emitting layer(s). Other factors influence the selection of the cathode such as the possibility of adverse interactions between the cathode and the light-emitting materials. The cathode may consist of a single material such as a layer of aluminium. Alternatively, it may comprise a plurality of metals, for example a bilayer of a low workfunction material and a high workfunction material such as calcium and aluminium as disclosed in WO 98/10621; elemental barium as disclosed in WO 98/57381, Appl. Phys. Lett. 2002, 81(4), 634 and WO 02/84759; or a thin layer of metal compound, in particular an oxide or fluoride of an alkali or alkali earth metal, to assist electron injection, for example lithium fluoride as disclosed in WO 00/48258; barium fluoride as disclosed in Appl. Phys. Lett. 2001, 79(5), 2001; and barium oxide. In order to provide efficient injection of electrons into the device, the cathode preferably has a workfunction of less than 3.5 eV, more preferably less than 3.2 eV, most preferably less than 3 eV. Work functions of metals can be found in, for example, Michaelson, J. Appl. Phys. 48(11), 4729, 1977.

The cathode may be opaque or transparent. Transparent cathodes are particularly advantageous for active matrix devices because emission through a transparent anode in such devices is at least partially blocked by drive circuitry located underneath the emissive pixels. A transparent cathode comprises a layer of an electron injecting material that is sufficiently thin to be transparent. Typically, the lateral conductivity of this layer will be low as a result of its thinness. In this case, the layer of electron injecting material is used in combination with a thicker layer of transparent conducting material such as indium tin oxide.

It will be appreciated that a transparent cathode device need not have a transparent anode (unless, of course, a fully transparent device is desired), and so the transparent anode used for bottom-emitting devices may be replaced or supplemented with a layer of reflective material such as a layer of aluminium. Examples of transparent cathode devices are disclosed in, for example, GB 2348316.

### Encapsulation

Organic optoelectronic devices tend to be sensitive to moisture and oxygen. Accordingly, the substrate preferably has good barrier properties for prevention of ingress of moisture and oxygen into the device. The substrate is commonly glass, however alternative substrates may be used, in particular where flexibility of the device is desirable. For example, the substrate may comprise a plastic as in US 6268695 which discloses a substrate of alternating plastic and barrier layers or a laminate of thin glass and plastic as disclosed in EP 0949850.

The device may be encapsulated with an encapsulant (not shown) to prevent ingress of moisture and oxygen. Suitable encapsulants include a sheet of glass, films having suitable barrier properties such as silicon dioxide, silicon monoxide, silicon nitride or alternating stacks of polymer and dielectric as disclosed in, for example, WO 01/81649 or an airtight container as disclosed in, for example, WO 01/19142. In the case of a transparent cathode device, a transparent encapsulating layer such as silicon monoxide or silicon dioxide may be deposited to micron levels of thickness, although in one preferred embodiment the thickness of such a layer is in the range of 20-300 nm. A getter material for absorption of any atmospheric moisture and / or oxygen that may permeate through the substrate or encapsulant may be disposed between the substrate and the encapsulant.

### Solution processing

Suitable solvents for forming compositions of the polymer for solution processing include many common organic solvents, such as mono-or poly-alkylbenzenes such as toluene and xylene.

Exemplary solution deposition techniques include printing and coating techniques such spin-coating, dip-coating, roll-to-roll coating or roll-to-roll printing, doctor blade coating, slot die coating, gravure printing, screen printing and inkjet printing.

Coating methods, such as those described above, are particularly suitable for devices wherein patterning of the light-emitting layer is unnecessary - for example for lighting applications or simple monochrome segmented displays.

Printing is particularly suitable for high information content displays, in particular full colour displays. A device may be inkjet printed by providing a patterned layer over the first electrode and defining wells for printing of one colour (in the case of a monochrome device) or multiple colours (in the case of a multicolour, in particular full colour device). The patterned layer is typically a layer of photoresist that is patterned to define wells as described in, for example, EP 0880303.

As an alternative to wells, the ink may be printed into channels defined within a patterned layer. In particular, the photoresist may be patterned to form channels which, unlike wells, extend over a plurality of pixels and which may be closed or open at the channel ends.

A number of methods may be used to at least partially avoid dissolution of an underlying organic layer during solution deposition of one or more further organic layers on the underlying organic layer. The underlying organic layer may be rendered insoluble by crosslinking prior to solution deposition of a further layer. Crosslinking may be provided by substituents on the materials forming the underlying layer, such as crosslinking substituents on the host and / or dopant material of a light-emitting layer. Alternatively or additionally, a crosslinkable additive may be included in the composition used to form the underlying layer. Alternatively or additionally, the further layer may be formed from a solution comprising a solvent in which the underlying organic layer is insoluble.

### Applications

OLEDs as described herein may be used in a wide range of applications, including but not limited to use as display backlights, for example LCD backlights, area illumination and displays. White light-emitting OLEDs may comprise uniform emissive layers. OLEDs for use in displays may comprise a patterned emissive layer or layers and / or a patterned electrode to provide individual display pixels.

### Examples

### Material Example 1

Phosphorescent orange emitter PO1 was prepared according to the following synthetic method:

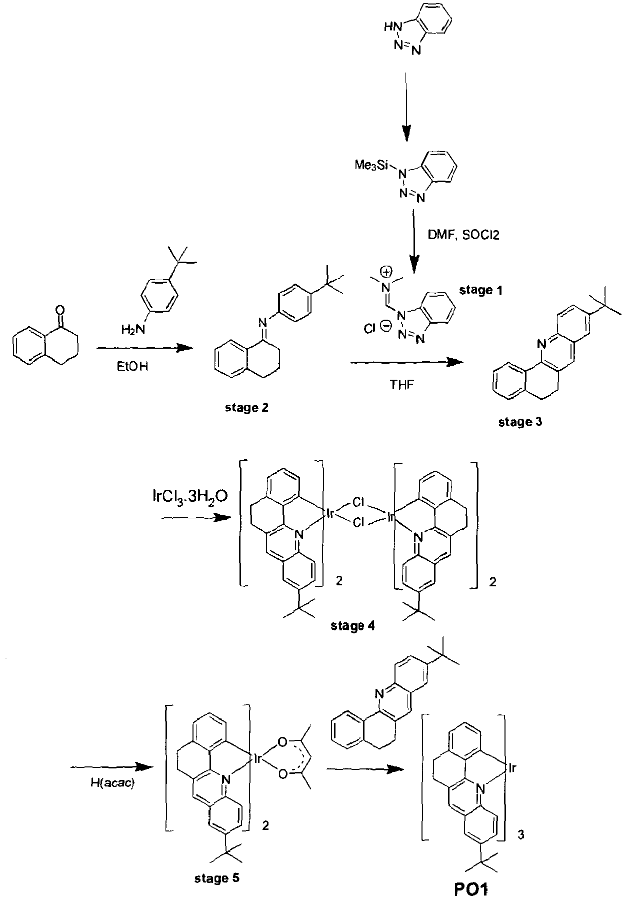

### Benzotriazole iminium salt PO1 stage1)

Benzotriazole iminium salt (PO1 stage1) was synthesised as described in C. Hartsborn, P. Steel, J. Heterocyclic Chem. 1996, 33, 1935 and used without further purification in the next step.

### 2-tert-butyl-5,6-dihydrobenzo[c]acridine (PO1 stage 3)

PO1 stage 3 was synthesised as described in A. Katritzky, M. Arend. J. Org. Chem. 1998, 63, 9989. Under nitrogen, 65.5g (439 mmol) 4-tert-butylaniline, 64.1g (439 mmol) α-tetralone, and approx. 50 mg para-toluenesulfonic acid in 500 ml toluene were heated under Dean-Stark conditions for two days. The reaction mixture was passed through Celite and all volatiles removed in vacuo to yield 115 g imine (95% yield).

Under nitrogen, 57g (1 eq, 206 mmol) imine (PO1 stage 2) was dissolved in 1L anhydrous THF, 65g (1.5 eq, 309 mmol) benzotriazole iminium salt (PO1 stage 1) was added as solid under stirring. The reaction mixture was stirred for 2h at RT and heated to reflux over night. After cooling to RT, the reaction was quenched via addition of 500 ml 2N sodium hydroxide solution. After phase separation, the aqueous layer was extracted twice with diethylether. The combined organic layers were dried over brine and magnesium sulphate and all volatiles removed in vacuo to yield 67 g brown oil. Column chromatography on silica with hexane/ethyl acetate 3:1 yielded 42g orange solid. Recrystallisation from 300 ml acetonitrile (cooled to -20 °C for 30 min prior to filtration) yielded 33g, >99.5% pure by GCMS, 99.3% pure by HPLC. Sublimation at 150 °C (10⁻⁶ mbar) yielded 25g PO1 stage 3, 99.8% pure by HPLC.

### Iridium dimer (PO1 stage 4)

A 250 ml 3-necked flask was charged with 5g (1 eq, 14.2 mmol) Iridium chloride hydrate and 10.2g (2.5 eq, 35 mmol) 2-tert-butyl-5,6-dihydrobenzo[c]acridine (PO1 stage 3). The flask was fitted with a condenser and overhead stirrer, and flushed with nitrogen for 30 min. In parallel, 35 ml 2-ethoxyethanol and 12 ml DI water in a dropping funnel were saturated with nitrogen for 30 min. The solvent was added, and the reaction mixture heated to 140 °C for two days. The resulting solid was filtered off, washed with a small amount ethoxyethanol and used without further purification in the next step.

### Iridium acac complex (PO1 stage 5)

11.4g (1 eq, 7.2 mmol) Iridium dimer (PO1 stage 4) and 7.6g (10 eq, 72 mmol) anhydrous sodium carbonate were weighed into a 250 ml 3-necked flask and the flask flushed with nitrogen for 30 min. In a dropping funnel 1.8g (2.5 eq, 18 mmol) 2,4-pentanedione (distilled) and 75 ml 2-ethoxyethanol were saturated with nitrogen for 20 min, and then added to Iridium dimer. The reaction was heated to 105 °C under nitrogen over night. After cooling to RT, the solid was collected on a sintered funnel, then added in small portions to 1L DI water under vigorous stirring. The solid was collected on a Buechner funnel, washed with 4x 200 ml D1 water and dried in air to yield 9g. The solid was dissolved in toluene, filtered through Celite and reduced to dryness to yield 7.4g red solid, 98.9% pure by HPLC.

### Emitter PO1

A 500 ml 3-necked flask was charged with 7.4g (1 eq, 8.6 mmol) Iridium acac complex (PO1 stage 5) and 2.58g (1.05 eq, 9 mmol) 2-tert-butyl-5,6-dihydrobenzo[c]acridine (PO1 stage 3) and flushed with nitrogen for 1h. In parallel, 150 ml 1,2-ethanediol was saturated with nitrogen for 1h in a dropping funnel. The solvent was added to the reaction vessel and the reaction heated to 175 °C (internal temperature) under nitrogen over night. After cooling to RT, the solid was collected on a Buechner funnel and washed with DI water. The solid was dissolved in approx. 500 ml warm toluene, filtered through Celite and reduced to dryness. Recrystallisation from 150 ml acetonitrile and 50 ml toluene yielded 4g, 98.7% by HPLC. Further recrystallisation from 60 ml acetonitrile and 30 ml toluene improved the purity to 98.9% by HPLC. Yield: 3.7g (41 %).

### PL spectrum of PO1

In Table 1 below are shown the peak photo luminescence wavelength of blends of emitter in HOST1 (5 % w/w).

For PLQY measurements films were spun from a suitable solvent (for example alkylbenzene, halobenzene, alkoxybenzene) on quartz disks to achieve transmittance values of 0.3-0.4. Measurements were performed under nitrogen in an integrating sphere connected to Hamamatsu C9920-02 with Mercury lamp E7536 and a monochromator for choice of exact wavelength.

**Table 1. Peak photo luminescence wavelength**

| Emitter | λₘₐₓ (nm) |
|---|---|
| PO1 | 582 |
| Comparative Emitter 1 | 618 |
| Comparative Emitter 2 | 592 |

### Material Example 2

Phosphorescent orange monomer PO2-Br was prepared according to the following synthetic method:

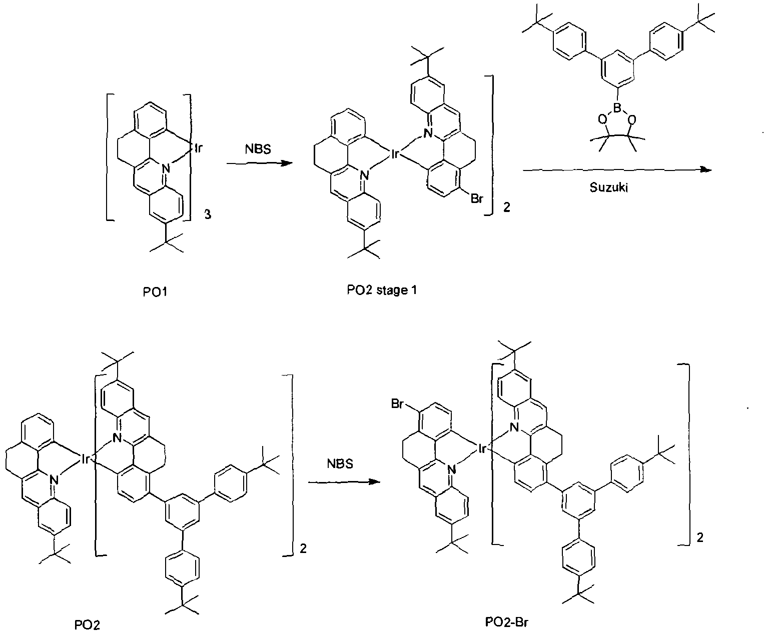

### PO2 stage 1

9.5g (1eq, 9 mmol) PO1 was dissolved in 2L anhydrous dichloromethane and saturated with nitrogen for 1.5 h. 3.22g (2eq, 18.1 mmol) NBS was added as solid and the solution stirred in the dark under nitrogen for 24 h. the reaction mixture was reduced to approx. 500 ml and washed several times with DI water. It was then dried over brine and magnesium sulfate and reduced to dryness to yield 10.4 g, 73.5% dibromide by HPLC.

### PO2

10.35g (1eq, 8.6 mmol) PO2 stage 1 and 12.03g (3eq, 25.7 mmol) boronate in 350 ml toluene were saturated with nitrogen for 1h. the suspension was heated to 50 °C to yield a clear solution. 297 mg (0.03eq, 0.26 mmol) Pd(PPh₃)₄ and 44 ml (7eq, 60 mmol) tetraethylammonium hydroxide (20 wt% in water) were added at this temperature. The emulsion was heated to 115 °C for 20 h. after cooling to RT and phase separation, the organic layer was dried over brine and magnesium sulfate and concentrated to dryness. Column chromatography on silica with hexane/ethyl acetate 4:1 yielded 18g red solid. Repeated column chromatography on an automated chromatography system (Biotage Isolera 1) yielded 8g, 99.4% pure by HPLC.

### PO2-Br

7.9g (1eq, 4.5 mmol) PO2 was dissolved in 1L anhydrous dichloromethane and saturated with nitrogen for 1h. 1.2g (1.5eq, 6.75 mmol) NBS was added as solid and the solution stirred in the dark for 2d. The reaction mixture was washed once with D1 water, dried over brine and magnesium sulfate and reduced to dryness to yield 9.2g. Repeated chromatography on an automated chromatography system yielded 1g, 96.7% pure by HPLC.

### Device Example 1

An organic light-emitting device having the following structure was formed on a glass substrate: ITO / HIL / HTL / EL / Cathode
wherein ITO is an indium-tin oxide anode; HIL is a layer of hole-injection material available from Plextronics Inc., HTL is a hole transport layer comprising hole transporting polymer HT1 formed by Suzuki polymerisation of monomers as disclosed in WO 00/53656 of monomers listed below; EL is a light-emitting layer comprising 75 mol % of host polymer Host1 formed by Suzuki polymerisation as disclosed in WO 00/53656 of monomers listed below, 24.5 mol % of phosphorescent green emitter PG1 and 0.5 mol % of phosphorescent orange emitter PO1; and Cathode is a cathode comprising a bilayer of a metal fluoride and aluminium.

Each of HIL, HTL and EL were formed by spin-coating a formulation from a solution in a solvent. Following deposition of HT1, the crosslinkable benzocyclobutane groups present in this polymer were crosslinked by heating to prevent dissolution of HTL upon spin-coating of the components of the light-emitting layer EL.

A white light-emitting device may be formed by providing a blue light-emitting material in the light-emitting layer, or by providing a separate blue light-emitting layer. A device having a fluorescent blue light-emitting layer and one or more phosphorescent layers are described in M. Kondakova et al. J. Appl. Phys. 2010, 107, 014515 and G. Schwartz et al., Adv. Funct. Mater. 2009, 19, 1319-1333

If more than one light-emitting layer is formed by a solution deposition method then a first light-emitting layer to be formed may be crosslinked in order to prevent dissolution of that layer upon solution deposition of a subsequent layer.

### General Device Process

A substrate carrying ITO was cleaned using UV / Ozone. The hole injection layer was formed by spin-coating an aqueous formulation of a hole-injection material available from Plextronics, Inc. A hole transporting layer HT1 or HT2 was formed to a thickness of 20 nm by spin-coating and crosslinked by heating. A light-emitting layer was formed by depositing a light-emitting formulation to a thickness of 75 nm by spin-coating from o-xylene solution. A cathode was formed by evaporation of a first layer of a metal fluoride to a thickness of about 2 nm, a second layer of aluminium to a thickness of about 200 nm and an optional third layer of silver.

**HT1**

| **Monomer** | **Mol %** |
|---|---|
| 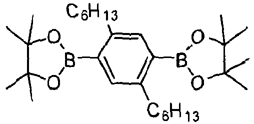 | 50 |
| 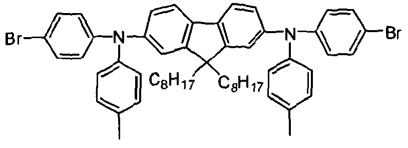 | 42.5 |
| 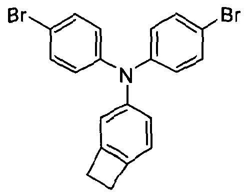 | 7.5 |

**Host1**

| **Monomer** | **Mol %** |
|---|---|
| 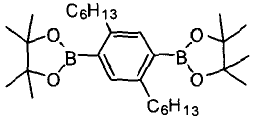 | 50 |
| 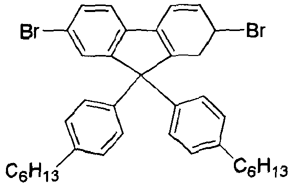 | 20 |
| 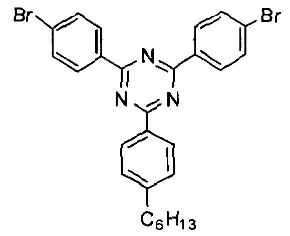 | 20 |
| 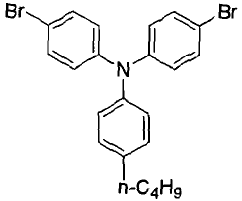 | 10 |

The molecular weight characteristics are recorded in Table 2. (GPC, relative to polystyrene standard).

Samples were prepared by dissolving 2 mg of polymer in 6 ml GPC grade THF (stabilised with 250 ppm BHT). Injection volume was 200 µl (injection loop), flowrate 1 ml/min, oven temperature 35°C. for separation 3 x 5 µm Mixed B PLgel 300 by 7.5mm columns with 5 µm Guard column were used. All GPC data quoted are relative to narrow polystyrene standards (used as received by Polymer Laboratories).

**Table 2. GPC data (relative to polystyrene standard)**

| Name | GPC / Dalton | | | |
|---|---|---|---|---|
| | Mw | Mp | Mn | Pd |
| HT1 | 361,000 | 317,000 | 38,000 | 9.55 |
| HOST1 | 407,000 | 373,000 | 140,000 | 2.91 |

### Emitters used in Device example 1:

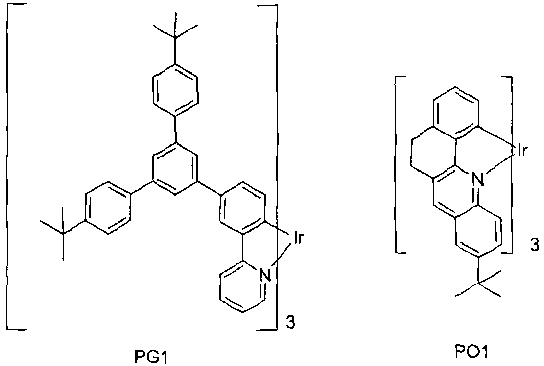

PG1 is a phosphorescent green emitter, PO1 is a phosphorescent orange emitter having a peak photoluminescent wavelength of around 582 nm.

### Comparative Example 1

For the purpose of comparison, a device was formed as described with reference to Example 1 except that emitter PO1 was replaced with Comparative Emitter 1, which is a phosphorescent red emitter having a peak photoluminescent wavelength of around 618 nm.

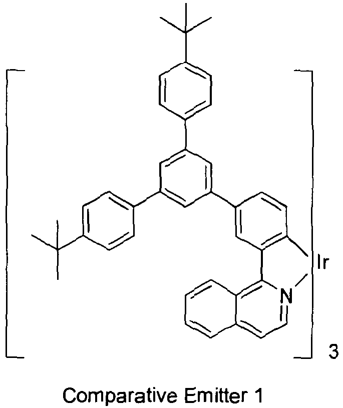

### Comparative Example 2

For the purpose of comparison, a device was formed as described with reference to Example I except that emitter PO1 was replaced with Comparative Emitter 2 which has a peak photo luminescent wavelength of around 592 nm.

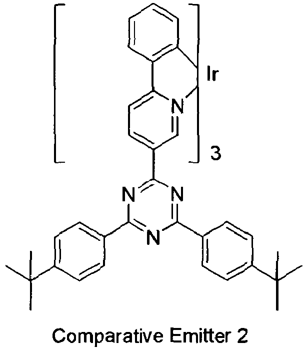

Devices were fabricated as described in the general section above. HT1 was used as hole transport layer. The composition of the emissive layer is shown in Table 3 below.

**Table 3**

| | Composition of the emissive layer (% w/w) | | |
|---|---|---|---|
| | Host1 | PG1 | Red emitter |
| Inventive Device example 1 | 75 | 24.5 | 0.5 |
| Comparative device example 1 | 75 | 24 | 1 |
| Comparative device example 2 | 75 | 24.5 | 0.5 |

Device results are set out below in Table 4. All measurements were taken at a device brightness of 1000 cd / m².

**Table 4**

| | Device performance at 1,000 cd/m² | | | | |
|---|---|---|---|---|---|
| | EQE (%) | Efficiency (Cd/A) | Efficiency (L /W) | Drive Voltage (V) | CIE (x, y) |
| Inventive Device Example 1 | 17.84 | 50.58 | 41.39 | 3.82 | 0.453, 0.522 |
| Comparative Device 1 | 15.02 | 27.81 | 20.98 | 4.16 | 0.453, 0.522 |
| Comparative Device 2 | 18.61 | 52.97 | 40.74 | 4.11 | 0.461, 0.515 |

It can be seen that external quantum efficiency (EQE), candela per ampere efficiency and lumen per watt efficiency of Inventive Device Example 1 are all higher than Comparative Example 1, and drive voltage of Inventive Device Example 1 is lower.

The sensitivity of the human eye to colours in the visible spectrum follows a curve that peaks at about 560 nm. Without wishing to be bound by any theory, it is believed that higher efficiency is achieved with phosphorescent orange emitter PO1 because the human eye is more sensitive to light emitted by this material than light emitted by Comparative Device containing Comparative Emitter 1.

As can be seen in Table 5, the LUMO of inventive example PO1 is 180 meV shallower compared to the LUMO of the host polymer HOST1. The LUMO of Comparative example 1 is 200 meV deeper. Without wishing to be bound by any theory, it is believed that the deep LUMO level of the emitter of Comparative Example 1 causes electron trapping and higher drive voltage.

**Table 5. HOMO/LUMO levels of emitters and HOST1**

| | HOMO (eV) | LUMO (eV) | LUMO (HOST1) - LUMO (emitter) (meV) |
|---|---|---|---|
| Inventive example PO1 | -5.24 | -2.53 | 180 |
| Comparative example 1 | -5.23 | -2.9 | -200 |
| Comparative example 2 | -5.1 | -2.8 | -90 |
| HOST1 | Out of range | -2.71 | na |

### Device example 2: Phosphorescent White Device

**HT2**

| **Monomer** | **Mol %** |
|---|---|
| 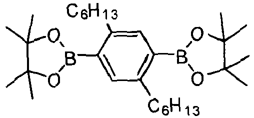 | 50 |
| 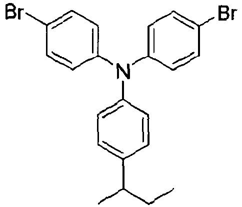 | 35 |
| 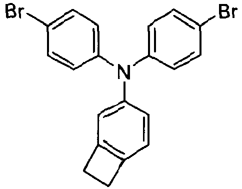 | 10 |
| 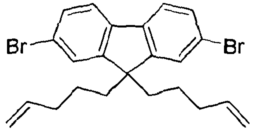 | 5 |

### Materials used as host in the emissive layer

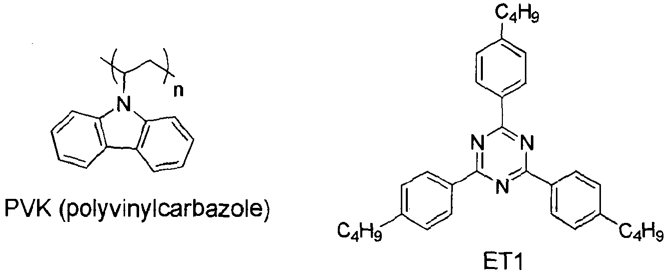

PVK (Sigma-Aldrich, average M_{w} 1,100,000 Dalton) was further purified by precipitation from chlorobenzene into methanol. ET1 was synthesised following the general procedure disclosed in WO 2008/025997.

**Table 6. GPC data (relative to polystyrene standard)**

| Name | GPC / Dalton | | | |
|---|---|---|---|---|
| | Mw | Mp | Mn | Pd |
| HT2 | 193,000 | 161,000 | 39,400 | 4.91 |

### Emitters used in Device example 2:

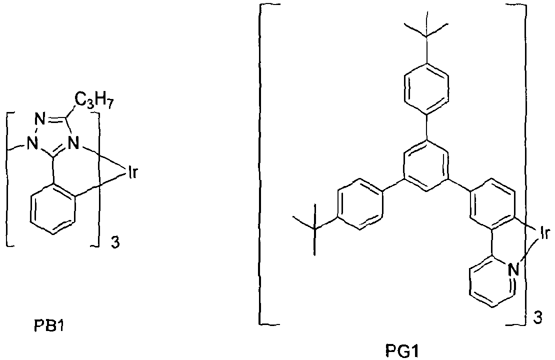

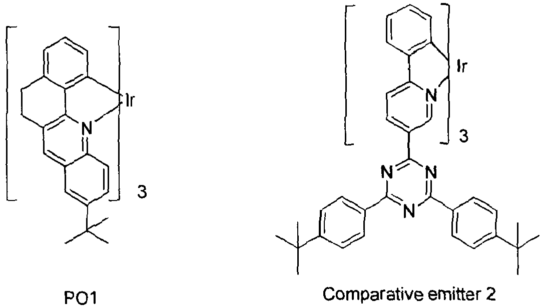

Devices were fabricated as described in the general section. HT2 was used as hole transport layer. The composition of the emissive layer is shown in Table 7 below.

**Table 7**

| | Composition of the emissive layer (% w/w) | | | | | |
|---|---|---|---|---|---|---|
| | PVK | ET1 | PB1 | PG1 | PO1 | Comparative emitter 2 |
| Inventive Device Example 2 | 68.7 | 20 | 10 | 0.9 | 0.4 | 0 |
| Comparative Device Example 2 | 68.7 | 20 | 10 | 0.9 | 0 | 0.4 |

Device results are set out below in Table 8. All measurements were taken at a device brightness of 1000 cd / m². It can be seen that external quantum efficiency (EQE), candela per ampere efficiency and lumen per watt efficiency of Device Example 2 are all higher than Comparative Example 2.

**Table 8**

| | Device performance at 1,000 cd/m² | | | | |
|---|---|---|---|---|---|
| | EQE (%) | Efficiency (Cd/A) | Efficiency (Lm/W) | Drive Voltage (V) | CIE (x, y) |
| Inventive Device example 2 | 13 | 34 | 12 | 9 | 0.391, 0.44 |
| Comparative Device example 2 | 12 | 29 | 9.5 | 9.6 | 0.388, 0.407 |

Note that when HOMO and LUMO levels of light-emitting materials and hosts are compared, they must be measured using the same measurement technique and conditions (for example by measuring both guest and host by cyclic voltammetry using the same electrolyte and reference electrode and temperature, or both guest and host by UPS spectroscopy).

## Claims

1. An organic light-emitting device comprising a first electrode, a second electrode and at least one light-emitting layer between the first and second electrodes wherein the device comprises a plurality of light-emitters that together provide a source of white light; wherein:
a first light-emitting layer comprises a host material and a first light-emitter of the plurality of light-emitters that emits light having a peak photoluminescent wavelength in the range of 580-605 nm;
a LUMO of the first light-emitter is the same as or closer to vacuum than a LUMO level of the host material,
the first light-emitter is a phosphorescent emitter of formula (I):
ML¹_{q}L²ᵣL³ₛ (I)
wherein M is a metal; L¹, L² and L³ each independently represent a coordinating group; q is an integer; r and s are each independently 0 or an integer; the sum of (a. q) + (b. r) + (c.s) is equal to the number of coordination sites available on M, wherein a is the number of coordination sites on L¹, b is the number of coordination sites on L²; and c is the number of coordination sites on L³;
L¹ is a ligand of formula (II); 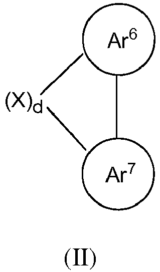
wherein Ar⁶ and Ar⁷ each independently represent an optionally substituted aromatic or heteroaromatic group comprising an atom capable of coordinating to M, d is at least 1 and X in each occurrence is selected from the group consisting of O, S, NR⁷ and -CR⁷₂- wherein R⁷ in each occurrence is H or a substituent;
the host material is blended with the first light-emitter and any other of the plurality of light-emitters present in the first light-emitting layer; and
the host material has formula (VII): 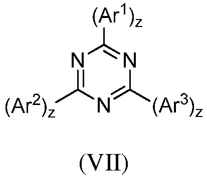 wherein Ar¹, Ar² and Ar³ are independently in each occurrence an optionally substituted aryl or heteroaryl group, and z independently in each occurrence is at least 1, optionally 1, 2 or 3.

2. An organic light-emitting device according to claim 1 wherein the first light-emitting layer comprises each of the plurality of light-emitters that together provide a source of white light.

3. An organic light-emitting device according to claim 1 wherein the device comprises the first light-emitting layer and at least one further light-emitting layer, each of the at least one further light-emitting layers containing at least one of the light-emitters that together with the first light-emitter provide a source of white light.

4. An organic light-emitting device according to any preceding claim wherein the first electrode is an anode; the second electrode is a cathode; and a hole transporting layer is disposed between the first electrode and the at least one light-emitting layer, wherein optionally the hole transporting layer is substantially non-emissive.

5. An organic light-emitting device according to any of claims 1-4 wherein the plurality of light-emitters are all phosphorescent.

6. An organic light-emitting device according to any one of the preceding claims wherein r and s are 0.

7. An organic light-emitting device according to any one of the preceding claims wherein M is iridium.

8. An organic light-emitting device according to claim 6 or 7 wherein R⁷ in each occurrence is H or C₁₋₂₀ alkyl.

9. An organic light-emitting device according to any one of the preceding claims wherein Ar⁶ comprises a N atom coordinated to M and Ar⁷ comprises a C atom coordinated to M.

10. An organic light-emitting device according to any preceding claim wherein the plurality of light-emitters that together provide a white light source include a blue light-emitter.

11. An organic light-emitting device according to claim 10 wherein the blue light-emitter is a fluorescent light-emitter, optionally a polymer comprising a blue light-emitting repeat unit of formula (V): 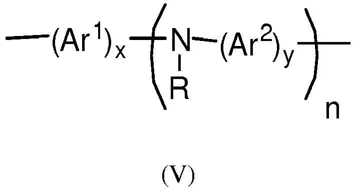 wherein Ar¹ and Ar² in each occurrence are independently selected from optionally substituted aryl or heteroaryl groups, n is greater than or equal to 1, preferably 1 or 2, R is H or a substituent, preferably a substituent, x and y are each independently 1, 2 or 3 and any of Ar¹, Ar² and R may be linked by a direct bond or a divalent linking group.

12. An organic light-emitting device according to claim 10 wherein the blue light-emitter is a phosphorescent light-emitter.

13. An organic light-emitting device according to any preceding claim wherein the plurality of light-emitters that together provide a white light source includes a green light-emitter, optionally a phosphorescent green emitter.

14. An organic light-emitting device according to any preceding claim wherein the white light has a CIE x coordinate equivalent to that emitted by a black body at a temperature in the range of 2500-9000K, optionally in the range of 2700-4500K, and a CIE y coordinate within 0.05, optionally within 0.025, of the CIE y co-ordinate of said light emitted by a black body.

15. A white light-emitting composition comprising a plurality of light-emitters that together provide a source of white light and a host material blended with the plurality of light-emitters, the composition comprising a phosphorescent metal complex of formula (I) that emits light having a peak photoluminescent wavelength in the range of 580-605 nm:
ML¹_{q}L²ᵣL³ₛ (I)
wherein M is a metal; L¹, L² and L³ each independently represent a coordinating group; q is an integer; r and s are each independently 0 or an integer; and the sum of (a. q) + (b. r) + (c.s) is equal to the number of coordination sites available on M, wherein a is the number of coordination sites on L¹, b is the number of coordination sites on L²; c is the number of coordination sites on L³; and L¹ is a coordinating group of formula (II): 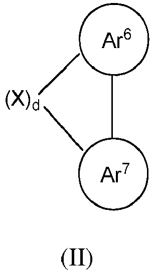
wherein Ar⁶ and Ar⁷ each independently represent an optionally substituted aromatic or heteroaromatic group comprising an atom capable of coordinating to M, d is at least 1 and X in each occurrence is selected from the group consisting of O, S, NR⁷ and -CR⁷₂ - wherein R⁷ in each occurrence is H or C₁₋₂₀ alkyl;
wherein the host material has formula (VII): 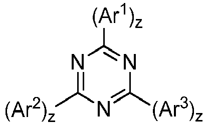 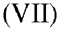
wherein Ar¹, Ar² and Ar³ are independently in each occurrence an optionally substituted aryl or heteroaryl group, and z independently in each occurrence is at least 1, optionally 1, 2 or 3; and
wherein a LUMO of the first light-emitter is the same as or closer to vacuum than a LUMO level of the host material.

## Patentansprüche

1. Organische lichtemittierende Vorrichtung, aufweisend eine erste Elektrode, eine zweite Elektrode und mindestens eine lichtemittierende Schicht zwischen den ersten und zweiten Elektroden, wobei die Vorrichtung eine Mehrzahl von Lichtemittern aufweist, die zusammen eine Quelle für weißes Licht bereitstellen; wobei:
eine erste lichtemittierende Schicht ein Wirtsmaterial und einen ersten Lichtemitter der Mehrzahl von Lichtemittern aufweist, der Licht mit einer Spitzen-Fotolumineszenzwellenlänge in dem Bereich von 580 bis 605 nm emittiert;
ein LUMO des ersten Lichtemitters dasselbe oder näher an einem Vakuum als ein LUMO-Pegel des Wirtsmaterials ist, der erste Lichtemitter ein phosphoreszierender Emitter gemäß der Formel (I) ist:
ML¹_{q}L²ᵣL³ₛ (I)
wobei M ein Metall ist; L¹, L² und L³ jeweils unabhängig eine Koordinierungsgruppe darstellen; q eine Ganzzahl ist; r und s jeweils unabhängig 0 oder eine Ganzzahl sind; die Summe von (a. q) + (b. r) + (c.s) gleich der Anzahl verfügbarer Koordinationsstellen auf M ist, wobei a die Anzahl von Koordinationsstellen auf L¹ ist, b die Anzahl von Koordinationsstellen auf L² ist und c Anzahl von Koordinationsstellen auf L³ ist;
L¹ ein Ligand von Formel (II) ist; 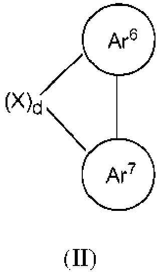
wobei Ar⁶ und Ar⁷ jeweils unabhängig eine optional substituierte aromatische oder heteroaromatische Gruppe darstellen, die ein Atom aufweist, das fähig ist, sich mit M zu koordinieren, d mindestens 1 ist und X in jedem Vorkommen aus der Gruppe ausgewählt wird, die aus O, S, NR⁷ und -CR⁷₂ besteht, - wobei R⁷ in jedem Vorkommen H oder ein Substituent ist;
das Wirtsmaterial mit dem ersten Lichtemitter und allen anderen der Mehrzahl von Lichtemittern vermischt wird, die in der ersten lichtemittierenden Schicht vorhanden sind;
und das Wirtsmaterial die Formel (VII) hat: 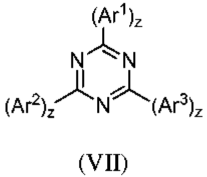
wobei Ar¹, Ar² und Ar³ in jedem Vorkommen unabhängig eine optional substituierte Aryl- oder Heteroarylgruppe sind, und z in jedem Vorkommen unabhängig mindestens 1, optional 1, 2 oder 3 ist.

2. Organische lichtemittierende Vorrichtung nach Anspruch 1, wobei die erste lichtemittierende Schicht jeden der Mehrzahl von Lichtemittern aufweist, die zusammen eine Quelle für weißes Licht bereitstellen

3. Organische lichtemittierende Vorrichtung nach Anspruch 1, wobei die Vorrichtung die erste lichtemittierende Schicht und mindestens eine weitere lichtemittierende Schicht aufweist, wobei jede der mindestens einen weiteren lichtemittierenden Schichten mindestens einen der Lichtemitter enthält, die zusammen mit dem ersten Lichtemitter eine Quelle für weißes Licht bereitstellen.

4. Organische lichtemittierende Vorrichtung nach einem der vorhergehenden Ansprüche, wobei die erste Elektrode eine Anode ist; die zweite Elektrode eine Kathode ist; und eine Lochtransportschicht zwischen der ersten Elektrode und der mindestens einen lichtemittierenden Schicht angeordnet ist, wobei die Lochtransportschicht optional im Wesentlichen nicht-emittierend ist.

5. Organische lichtemittierende Vorrichtung nach einem der Ansprüche 1 bis 4, wobei die gesamte Mehrzahl von Lichtemittern phosphoreszierend ist.

6. Organische lichtemittierende Vorrichtung nach einem der vorhergehenden Ansprüche, wobei r und s 0 sind.

7. Organische lichtemittierende Vorrichtung nach einem der vorhergehenden Ansprüche, wobei M Iridium ist.

8. Organische lichtemittierende Vorrichtung nach Anspruch 6 oder 7, wobei R⁷ in jedem Vorkommen H oder C₁₋₂₀-Alkyl ist.

9. Organische lichtemittierende Vorrichtung nach einem der vorhergehenden Ansprüche, wobei Ar⁶ ein mit M koordiniertes N-Atom aufweist und Ar⁷ ein mit M koordiniertes C-Atom aufweist.

10. Organische lichtemittierende Vorrichtung nach einem der vorhergehenden Ansprüche, wobei die Mehrzahl von Lichtemittern, die zusammen eine Quelle für weißes Licht bereitstellen, einen Blaulichtemitter enthalten.

11. Organische lichtemittierende Vorrichtung nach Anspruch 10, wobei der Blaulichtemitter ein fluoreszierender Lichtemitter ist, optional ein Polymer, das eine Blaulicht emittierende Wiederholungseinheit nach Formel (V) aufweist: 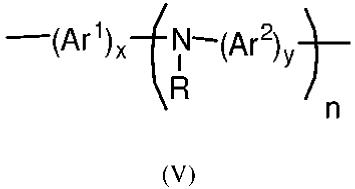 wobei Ar¹ und Ar² in jedem Vorkommen unabhängig aus optional substituierten Aryl- oder Heteroarylgruppen gewählt werden, n größer oder gleich 1 ist, bevorzugt 1 oder 2, R H oder ein Substituent ist, bevorzugt ein Substituent, x und y jeweils unabhängig 1, 2 oder 3 sind, und jedes von Ar¹, Ar² und R durch eine direkte Bindung oder eine zweiwertige Verbindungsgruppe verbunden werden können.

12. Organische lichtemittierende Vorrichtung nach Anspruch 10, wobei der Blaulichtemitter ein phosphoreszierender Lichtemitter ist.

13. Organische lichtemittierende Vorrichtung nach einem der vorhergehenden Ansprüche, wobei die Mehrzahl von Lichtemittern, die zusammen eine Quelle für weißes Licht bereitstellen, einen Grünlichtemitter, optional einen phosphoreszierenden Grünemitter enthalten.

14. Organische lichtemittierende Vorrichtung nach einem der vorhergehenden Ansprüche, wobei das weiße Licht eine CIE-x-Koordinate entsprechend derjenigen hat, die durch einen schwarzen Körper bei einer Temperatur in dem Bereich von 2500 bis 9000K, optional in dem Bereich von 2700 bis 4500 H emittiert wird, und eine CIE-y-Koordinate innerhalb von 0,05, optional innerhalb von 0,025 der CIE-y-Koordinate des Lichts, das von einem schwarzen Körper emittiert wird.

15. Weißes Licht emittierende Zusammensetzung, aufweisend eine Mehrzahl von Lichtemittern, die zusammen eine Quelle für weißes Licht bereitstellen, und ein mit der Mehrzahl von Lichtemittern vermischtes Wirtsmaterial, wobei die Zusammensetzung einen phosphoreszierenden Metallkomplex der Formal (I) aufweist, der Licht mit einer Spitzen-Fotolumineszenzwellenlänge in dem Bereich von 580 bis 605 nm emittiert;
ML¹_{q}L²ᵣL³ₛ (I)
wobei M ein Metall ist; L¹, L² und L³ jeweils unabhängig eine Koordinierungsgruppe darstellen; q eine Ganzzahl ist; r und s jeweils unabhängig 0 oder eine Ganzzahl sind; die Summe von (a. q) + (b. r) + (c.s) gleich der Anzahl verfügbarer Koordinationsstellen auf M ist, wobei a die Anzahl von Koordinationsstellen auf L¹ ist, b die Anzahl von Koordinationsstellen auf L² ist; c Anzahl von Koordinationsstellen auf L³ ist; und L¹ eine Koordinierungsgruppe der Formel (II) ist: 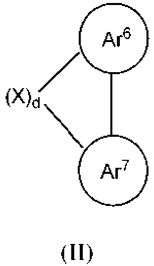
wobei Ar⁶ und Ar⁷ jeweils unabhängig eine optional substituierte aromatische oder heteroaromatische Gruppe darstellen, die ein Atom aufweist, das fähig ist, sich mit M zu koordinieren, d mindestens 1 ist und X in jedem Vorkommen aus der Gruppe ausgewählt wird, die aus O, S, NR⁷ und -CR⁷₂ besteht, - wobei R⁷ in jedem Vorkommen H oder ein C₁₋₂₀-Alkyl ist;
wobei das Wirtsmaterial die Formel (VII) hat: 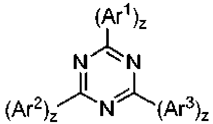
wobei Ar¹, Ar² und Ar³ in jedem Vorkommen unabhängig eine optional substituierte Aryl- oder Heteroarylgruppe sind, und z in jedem Vorkommen unabhängig mindestens 1, optional 1, 2 oder 3 ist;
und wobei ein LUMO des ersten Lichtemitters dasselbe oder näher an einem Vakuum als ein LUMO-Pegel des Wirtsmaterials ist.

## Revendications

1. Dispositif photoémetteur organique comprenant une première électrode, une deuxième électrode et au moins une couche photoémettrice entre les première et deuxième électrodes, le dispositif comprenant une pluralité de photoémetteurs qui fournissent ensemble une source de lumière blanche ; dans lequel :
une première couche photoémettrice comprend un matériau hôte et un premier photoémetteur de la pluralité de photoémetteurs qui émet une lumière ayant une longueur d'onde photo luminescente de pointe dans la gamme de 580-605 nm ;
un LUMO du premier photoémetteur est le même ou plus proche du vide qu'un niveau de LUMO du matériau hôte,
le premier photoémetteur est un émetteur phosphorescent de formule (I) :
ML¹_{q}L²ᵣL³, (I)
où M est un métal ; L¹ , L² et L³ représentent chacun indépendamment un groupe de coordination ; q est un nombre entier ; r et s sont chacun indépendamment 0 ou un nombre entier ; la somme de (a. q) + (b. r) + (c.s) est égale au nombre de sites de coordination disponibles sur M, où a est le nombre de sites de coordination sur L¹, b est le nombre de sites de coordination sur L² ; et c est le nombre de sites de coordination sur L³ ;
L¹ est un ligand de formule (II) : 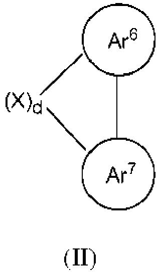
où Ar⁶ et Ar⁷ représentent chacun indépendamment un groupe aromatique ou hétéroaromatique optionnellement substitué comprenant un atome capable de coordination à M, d est au moins 1 et X est, dans chaque occurrence, sélectionné dans le groupe constitué de O, S, NR⁷ et -CR⁷₂ - où R⁷ est, dans chaque occurrence, H ou un substituant ;
le matériau hôte est mêlé au premier photoémetteur et à tout autre de la pluralité de photoémetteurs présents dans la première couche photoémettrice ; et
le matériau hôte a la formule (VII) : 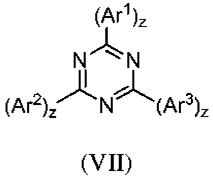
où Ar¹, Ar² et Ar³ sont indépendamment, dans chaque occurrence, un groupe aryle ou hétéroaryle optionnellement substitué, et z est, indépendamment dans chaque occurrence, au moins 1, optionnellement 1, 2 ou 3.

2. Dispositif photoémetteur organique selon la revendication 1, dans lequel la première couche photoémettrice comprend chacun de la pluralité de photoémetteurs qui fournissent ensemble une source de lumière blanche.

3. Dispositif photoémetteur organique selon la revendication 1, le dispositif comprenant la première couche photoémettrice et au moins une autre couche photoémettrice, chacune de la ou des autres couches photoémettrices contenant au moins un des photoémetteurs qui, conjointement avec le premier photoémetteur, fournissent une source de lumière blanche.

4. Dispositif photoémetteur organique selon l'une quelconque des revendications précédentes, dans lequel la première électrode est une anode ; la deuxième électrode est une cathode ; et une couche de transport d'électrons-trous est disposée entre la première électrode et la ou les couches photoémettrices, dans lequel, optionnellement, la couche de transport d'électrons-trous est substantiellement non émissive.

5. Dispositif photoémetteur organique selon l'une quelconque des revendications 1-4 dans lequel la pluralité de photoémetteurs sont tous phosphorescents.

6. Dispositif photoémetteur organique selon l'une quelconque des revendications précédentes, dans lequel r et s sont 0.

7. Dispositif photoémetteur organique selon l'une quelconque des revendications précédentes dans lequel M est l'iridium

8. Dispositif photoémetteur organique selon la revendication 6 ou 7, dans lequel R⁷, dans chaque occurrence, est H ou C₁₋₂₀ alkyle.

9. Dispositif photoémetteur organique selon l'une quelconque des revendications précédentes, dans lequel Ar⁶ comprend un atome N coordonné à M, et Ar⁷ comprend un atome C coordonné à M.

10. Dispositif photoémetteur organique selon l'une quelconque des revendications précédentes, dans lequel la pluralité de photoémetteurs qui fournissent ensemble une source de lumière blanche incluent un émetteur de lumière bleue.

11. Dispositif photoémetteur organique selon la revendication 10, dans lequel l'émetteur de lumière bleue est un photoémetteur fluorescent, optionnellement un polymère comprenant une unité de répétition émettant une lumière bleue de formule (V) : 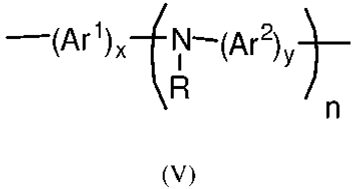 où Ar¹ et Ar², dans chaque occurrence, sont sélectionnés indépendamment entre des groupes aryle ou hétéroaryle optionnellement substitués, n est supérieur ou égal à 1, de préférence 1 ou 2, R est H ou un substituant, de préférence un substituant, x et y sont chacun indépendamment 1, 2 ou 3 et l'un quelconque de Ar¹, Ar² et R peut être lié par une liaison directe ou un groupe de liaison bivalent.

12. Dispositif photoémetteur organique selon la revendication 10, dans lequel l'émetteur de lumière bleue est un photoémetteur phosphorescent.

13. Dispositif photoémetteur organique selon l'une quelconque des revendications précédentes, dans lequel la pluralité de photoémetteurs qui fournissent ensemble une source de lumière blanche comprend un émetteur de lumière verte, optionnellement un émetteur de lumière verte phosphorescent.

14. Dispositif photoémetteur organique selon l'une quelconque des revendications précédentes, dans lequel la lumière blanche a une coordonnée CIE x équivalente à celle émise par un corps noir à une température dans la gamme de 2500-9000K, optionnellement dans la gamme de 2700-4500K, et une coordonnée CIE y à 0,05 maximum, optionnellement à 0,025 maximum de la coordonnée CIE y de ladite lumière émise par un corps noir.

15. Composition émettant une lumière blanche comprenant une pluralité de photoémetteurs qui fournissent ensemble une source de lumière blanche et un matériau hôte mêlé à la pluralité de photoémetteurs, la composition comprenant un complexe métallique phosphorescent de formule (I) qui émet une lumière ayant une longueur d'onde photoluminescente de pointe dans la gamme de 580-605 nm :
ML¹_{q}L²ᵣL³ₛ (I)
où M est un métal ; L¹, L² et L³ représentent chacun indépendamment un groupe de coordination ; q est un nombre entier ; r et s sont chacun indépendamment 0 ou un nombre entier ; et la somme de (a. q) + (b. r) + (c.s) est égale au nombre de sites de coordination disponibles sur M, a étant le nombre de sites de coordination sur L¹, b étant le nombre de sites de coordination sur L²; c étant le nombre de sites de coordination sur L³ ; et L¹ étant un groupe de coordination de formule (II) : 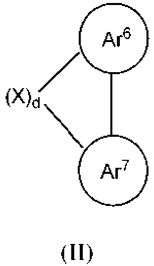
où Ar⁶ et Ar⁷ représentent chacun indépendamment un groupe aromatique ou hétéroaromatique optionnellement substitué comprenant un atome capable de coordination à M, d est au moins 1 et X, dans chaque occurrence, est sélectionné dans le groupe constitué de O, S, NR⁷ et -CR⁷₂ - où R⁷, dans chaque occurrence, est H ou C₁₋₂₀ alkyle;
où le matériau hôte a la formule (VII): 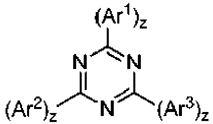
où Ar¹, Ar² et Ar³ sont indépendamment, dans chaque occurrence, un groupe aryle ou hétéroaryle optionnellement substitué, et z, indépendamment dans chaque occurrence, est au moins 1, optionnellement 1, 2 ou 3 ; et
où un LUMO du premier photoémetteur est le même que, ou plus proche du vide qu'un niveau de LUMO du matériau hôte.
